# EUROPEAN PATENT APPLICATION

(11) **EP 2 650 405 A2**
(43) Date of publication of application: **16.10.2013**
(21) Application number: 13174922.8
(22) Date of filing: 03.11.2009
(51) Int. Cl.: C30B 15/00, C30B 29/06

(54) **Methods for preparing a melt of silicon powder for silicon crystal growth**

(30) Priority: 05.11.2008 US 111536 P
(62) Divisional of application: 09745266.8
(71) Applicant: MEMC Singapore Pte. Ltd., Singapore 048424 (SG)
(72) Inventor: Massoud, Javidi, St. Peters, MO Missouri 63376 (US); Kimbel, Steven L., St. Peters, MO Missouri 63376 (US)
(74) Representative: Maiwald Patentanwalts GmbH

(57) **Abstract**

Methods for preparing a melt from silicon powder for use in growing a single crystal or polycrystalline silicon ingot in accordance with the Czochralski method that include removal of silicon oxides from the powder; application of a vacuum to remove air and other oxidizing gases; controlling the position of the charge relative to the heater during and after melting of the powder and maintaining the charge above its melting temperature for a period of time to allow oxides to dissolve; and use of a removable spacer between the crucible sidewall and the silicon powder charge to reduce oxides and silicon bridging.

## Description

### BACKGROUND

The field of the invention relates generally to preparation of a melt of silicon powder for use in growing silicon ingots and, particularly, to preparation of melts of silicon powder for utilization in production of single crystal or polycrystalline silicon ingots.

Most single crystal silicon used for microelectronic circuit fabrication is prepared by the Czochralski ("Cz") process. In this process, a single crystal silicon ingot is produced by melting polycrystalline silicon ("polysilicon") in a crucible, dipping a seed crystal into the molten silicon, withdrawing the seed crystal in a manner sufficient to achieve the diameter desired for the ingot, and growing the single crystal at that diameter.

The polysilicon melted to form the molten silicon is typically chunk polysilicon prepared by the Siemens process or granular polysilicon prepared by a fluidized bed reaction process. Chunk polysilicon is generally irregular in shape, having sharp, jagged edges as a result of the fact that it is prepared by breaking rods of polysilicon into smaller pieces which typically range from about 2 cm to about 10 cm in length and from about 4 cm to about 6 cm in width. Granular polysilicon is much smaller than the chunk and generally has a uniform, spherical shape that can be used to form the melt. Granular polysilicon is typically about 0.5 to about 5 mm in diameter. The preparation and characteristics of both chunk and granular polysilicon are further detailed in F. Shimura, Semiconductor Silicon Crystal Technology, pages 116-121, Academic Press (San Diego Calif., 1989) and the references cited therein which is incorporated herein by reference for all relevant and consistent purposes.

Due to growing demand for photovoltaic cells (i.e., solar cells), polysilicon is in short supply and it has become even more desirable to maximize the utilization of sources of silicon (e.g., using feedstock other than chunk polysilicon and granular polysilicon) for the production of both single crystal silicon and multicrystal silicon. Thus, a need exists for production processes that use non-conventional silicon feedstock and which recognize and overcome the technical challenges presented by use of such non-conventional feedstocks.

Silicon powder, a by-product of the granular silicon fluidized bed process, has generally been used in less valuable industrial applications such as, for example, as an additive in steel production. As a result, silicon powder is sold at a large discount as compared to granular and chunk polycrystalline silicon. A need exists for production processes that enable the use of silicon powder as a feedstock for production of higher value products such as single crystal or polycrystalline silicon.

### BRIEF SUMMARY

One aspect of the present invention is directed to a process for preparing a melt of silicon powder for use in growing a single crystal or polycrystalline silicon ingot in accordance with the Czochralski method. Silicon powder is loaded into a crucible to form a silicon charge comprising at least about 20% silicon powder by weight. The silicon powder includes silicon powder particles with an amount of silicon oxide at their surface. The crucible is located within a housing of a crystal puller for pulling the silicon ingot. The silicon charge is heated to a temperature from about 1100°C to a temperature less than about the melting temperature of the silicon charge for at least about 30 minutes to remove silicon oxides from the charge. The silicon charge is heated to a temperature above the melting temperature of the charge to form a silicon melt.

Another aspect of the present invention is directed to a process for preparing a melt of silicon powder for use in growing a single crystal or polycrystalline silicon ingot in accordance with the Czochralski method. Silicon powder is loaded into a crucible to form a silicon charge. The crucible is located within a housing of a crystal puller for pulling the silicon ingot. The housing includes an ambient. A portion of the ambient is removed to create a vacuum in the housing. The rate of removal of the ambient is controlled to prevent silicon powder from becoming entrained in the ambient. The silicon charge is heated to a temperature above the melting temperature of the charge to form a silicon melt.

In another aspect of a process for preparing a melt of silicon powder for use in growing a single crystal or polycrystalline silicon ingot in accordance with the Czochralski method, silicon powder is loaded into a crucible to form a silicon charge. The crucible is located within a housing of a crystal puller for pulling the silicon ingot. The crystal puller has a heater in thermal communication with the crucible for heating the crucible to a temperature sufficient to melt the silicon charge. The heater has a top and a bottom that define a heater length and an axial centerpoint midway between the top and the bottom of the heater. The crucible is capable of being raised and lowered within the housing along a central longitudinal axis of the crystal puller. The charge has an axial centerpoint midway between the surface of the charge and the bottom of the charge. The silicon charge held by the crucible is heated to form a silicon melt having a surface while the crucible is held at a first axial position wherein the distance between the axial centerpoint of the charge and the axial centerpoint of the heater is less than about 15% of the heater length. The crucible is positioned at a second axial position wherein the distance between the surface of the melt and the axial centerpoint of the heater is less than about 15% of the heater length. The temperature of the silicon melt is maintained above the melting temperature of the charge at the second axial position for at least about 30 minutes.

A further aspect of the present invention is directed to a process for preparing a melt of silicon powder for use in growing a single crystal or polycrystalline silicon ingot in accordance with the Czochralski method. The silicon melt is prepared in a crucible having a bottom and a sidewall having an inner surface. A removable spacer is inserted along the inner surface of the crucible sidewall. The spacer has a top and a bottom. Silicon powder is loaded into the crucible to form a silicon charge. The removable spacer is removed from the crucible to create a gap between the sidewall of the crucible and the silicon charge. The silicon charge is heated to a temperature above the melting temperature of the charge to form a silicon melt.

In yet another aspect for preparing a melt of silicon powder for use in growing a single crystal or polycrystalline silicon ingot in accordance with the Czochralski method, silicon powder is loaded into a crucible having a bottom and a sidewall having an inner surface to form a silicon charge. The silicon powder includes silicon powder particles with an amount of silicon oxide at their surface. A removable spacer is inserted along the inner surface of the crucible sidewall. The spacer has a top and a bottom. The removable spacer is removed from the crucible to create a gap between the sidewall of the crucible and the silicon charge. The crucible is loaded within a housing of a crystal puller for pulling the silicon ingot. The housing includes an ambient. The crystal puller has a heater in thermal communication with the crucible for heating the crucible to a temperature sufficient to melt the silicon charge. The heater has a top and a bottom that define a heater length and an axial centerpoint midway between the top and the bottom of the heater. The crucible is capable of being raised and lowered within the housing along a central longitudinal axis of the crystal puller. The charge has an axial centerpoint midway between the surface of the charge and the bottom of the charge. A portion of the ambient is removed to create a vacuum in the housing. The rate of removal of the ambient is controlled to prevent silicon powder from becoming entrained in the ambient. The silicon charge is heated to a temperature from about 1100°C to a temperature less than about the melting temperature of the silicon charge for at least about 30 minutes to remove silicon oxides from the charge. The silicon charge is heated to a temperature above the melting temperature of the charge to form a silicon melt having a surface while the crucible is held at a first axial position wherein the distance between the axial centerpoint of the charge and the axial centerpoint of the heater is less than about 15% of the heater length. The crucible is positioned at a second axial position wherein the distance between the surface of the melt and the axial centerpoint of the heater is less than about 15% of the heater length. The temperature of the silicon melt is maintained above the melting temperature of the charge at the second axial position for at least about 30 minutes.

Various refinements exist of the features noted in relation to the above-mentioned aspects of the present invention. Further features may also be incorporated in the above-mentioned aspects of the present invention as well. These refinements and additional features may exist individually or in any combination. For instance, various features discussed below in relation to any of the illustrated embodiments of the present invention may be incorporated into any of the above-described aspects of the present invention, alone or in any combination.

### BRIEF DESCRIPTION OF THE DRAWINGS

Fig. 1 is a cross-sectional view of a silicon powder charge within a crucible loaded in a pulling apparatus;

Fig. 2 is a cross-sectional view of a silicon powder charge within a crucible at a first axial position relative to a heater;

Fig. 3 is a cross-sectional view of a silicon melt within a crucible at a second axial position relative to a heater;

Fig. 4 is a cross-sectional view of a silicon melt within a crucible at a third axial position relative to a heater; and

Fig. 5 is a cross-sectional view of a silicon ingot being pulled from a silicon melt in a pulling apparatus.

Corresponding reference characters indicate corresponding parts throughout the several views of the drawings.

### DETAILED DESCRIPTION

The methods of the present invention are directed to the preparation of melts of silicon powder for use in crystal growth. Among the methods are provisions for removal of silicon oxides from the powder; application of a vacuum to remove air and other oxidizing gases; controlling the position of the charge relative to the heater during melting of the charge to more effectively melt the charge and controlling the position of the charge relative to the heater while maintaining the charge above its melting temperature for a period of time to allow oxides to dissolve; and use of a removable spacer between the crucible sidewall and the silicon powder charge.

Silicon powder has been traditionally considered a low value by-product of granular polysilicon production. Granular polysilicon may be produced by a chemical vapor deposition mechanism in a fluidized bed reactor. A fluidizing gas that contains a thermally decomposable compound such as silane or halosilanes is introduced into a reaction chamber of a fluidized bed reactor to suspend silicon particles in the reaction chamber. Silicon deposits from the thermally decomposable silicon compound onto the silicon particles in the reaction chamber. The silicon particles continuously grow in size until they are removed from the reactor as polycrystalline silicon product (i.e., "granular"' polycrystalline silicon).

A variety of reactions may take place in the reaction chamber during the granular polysilicon production process. In a silane system, silane heterogeneously deposits onto the growing crystal particle and may also decompose to produce silicon vapor. The silicon vapor can homogenously nucleate to form undesirable silicon powder (synonymously referred to as silicon "dust"). As silicon deposits from the silane onto the growing silicon particle, hydrogen is released from the silane molecule.

The silicon powder is carried out of the reactor with the hydrogen gas and unreacted silane as well as carrier gases typically added to the reactor with the silane (collectively "spent gas") that exit the reactor. The silicon powder is separated from the spent gas that exits the reactor by, for example, bag-filtration, cyclone separation or liquid scrubbers. Typically, the average nominal diameter of the silicon powder particles is less than about 50 µm.

Processes of embodiments of the present invention allow silicon powder to be utilized as a feedstock for production of ingots (synonymously "rods") of single crystal silicon or polycrystalline silicon. Ingots of polycrystalline silicon may be further processed to produce single crystal silicon or multicrystalline silicon.

### Difficulties Encountered in Using Silicon Powder as a Feedstock

The use of silicon powder as a source of silicon for single crystal silicon or polycrystalline silicon growth presents a number of challenges. For example, due to the small particle size of silicon powder, silicon powder formed within a crucible to form a silicon charge contains a large amount of open space which is typically filled with air. The oxygen within the air can react to form silicon oxides upon melting of the silicon powder. The silicon oxides can become incorporated within the growing silicon ingot causing structural defects (e.g., inclusions and dislocations) to form within the ingot.

After the production of granular polycrystalline silicon by the chemical vapor deposition fluidized bed process, granular silicon and silicon powder separated from the fluidizing gas are both exposed to air resulting in the formation of a thin layer of silicon oxides on the surface of the granular polysilicon and the silicon powder particles. This thin layer of silicon oxides at the surface of the particles may be from about 20 µm to about 40 µm thick. Because of the small particle size of silicon powder, silicon oxides at the surface of the powder typically constitute a higher mass percentage of the silicon powder particle than of the granular polysilicon particle, with the amount of silicon oxides being as much as about 1% by weight of the silicon powder. Once a charge of silicon powder begins to melt, these oxides can agglomerate into solid formations below and at the surface of the melt. These solid formations can interfere with the solid-melt interface during ingot growth and cause loss of single crystal structure within the growing ingot. Alternatively, the silicon oxides can become trapped within the melt and become incorporated into the ingot causing structural and electrical defects (e.g., inclusions and dislocations) in the resulting semiconductor wafers.

Because much of a silicon charge formed from silicon powder contains open space, the volume of the molten silicon is less than the volume of the initial silicon powder charge. This leads to complications during silicon meltdown. For instance, during meltdown silicon powder at the lower portion of the charge near the silicon heater (i.e., powder contacting the crucible sidewall) melts inwards away from the heater forming a column of powder in the center of the crucible. Towards the later stages of the meltdown, the powder charge has a mushroom form with a column of powder and a heavy upper cap. Liquid silicon flows into the cooler regions of the powder charge and resolidifies. A significant amount of liquid is wicked into the upper cap and resolidifies. Once the upper cap becomes saturated with solidifying liquid, a pool of melt forms at the bottom of the crucible. This melt pool weakens the column and eventually causes the column and upper cap to forcefully collapse (herein referred to as a "hard-drop"), an event that may cause costly breakage of the crucible.

During meltdown in crystal pullers without an upper heat shield, for example as shown and described in U.S. Patent No. 6,797,062, which is incorporated herein for all relevant and consistent purposes, the lower portion of the powder charge can melt away and leave a "hanger" of unmelted material that sticks to the crucible wall over the melt. Alternatively, a "bridge" of unmelted material can form which extends between opposing sides of the crucible wall and over the melt. After capillary uptake of further molten silicon into the bridge, the bridge becomes heavy and can cause thermomechanical buckling of the crucible. If a hanger or a bridge collapses, it may cause molten silicon to be splattered, or cause mechanical stress damage to the crucible. Further, because of poor thermal contact between the hanger or bridge and the molten silicon, a longer time is required to melt the entire silicon charge. Although the presence of an upper heat shield can reduce both of these events, it can also limit the total volume of powder within the charge and may cause an increase in entrainment of powder into process gas flows.

### Silicon Powder Feedstock

In one embodiment of the present invention, the silicon powder feedstock used to prepare the silicon powder charge comprises powder collected from a fluidized bed reactor utilized in the chemical vapor deposition of silicon from a thermally decomposable compound. In another embodiment, the silicon powder feedstock and the resulting charge comprise silicon powder particles less than about 50 µm in nominal diameter.

The silicon powder charge may contain an amount of granular or chunk polysilicon in addition to silicon powder. In one embodiment of the present invention, the silicon powder charge includes at least about 20% silicon powder by weight. In other embodiments, the charge contains at least about 35% silicon powder by weight and, according to other embodiments, at least about 50% silicon powder by weight or even about 75% silicon powder by weight. In one embodiment, the silicon charge includes at least about 90% by weight silicon powder or even 99% silicon powder by weight. In yet another embodiment, the silicon charge consists essentially of silicon powder.

### Preparation of the Silicon Powder Charge

In crystal silicon production methods that involve use of granular or chunk polycrystalline silicon, the chunk or granular silicon is loaded into the crucible and the chunk or granular particles directly contact the crucible sidewall. It has been found that when silicon powder is loaded into the crucible in the same manner, hard-drops, hangers and bridges of silicon powder often result. According to one aspect of the present invention, a gap is formed between the crucible sidewall and a portion of the silicon powder charge to prevent hard-drops from occurring and to prevent hangers and bridges from forming. This gap is formed by inserting a removable spacer into the crucible against the crucible sidewall. Once silicon powder is loaded into the crucible the spacer is removed to create the gap between the silicon powder and the crucible sidewall.

The removable spacer may be constructed of a wide variety of materials and, in one embodiment, is constructed of a material that maintains its shape against the weight of the silicon powder as the silicon powder is loaded into the crucible but is sufficiently pliable to conform to the curved crucible sidewall. Suitable materials include deformable materials such as polyurethane or polyethylene foam, or hard materials such as various thermoplastics. The spacer may be rectangular in shape or both ends of the spacer may be joined to form an annulus.

In one embodiment, the length of the spacer is at least about the length of the inner circumference of the crucible. Alternatively, a plurality of spacers may be used, wherein the combined length of the spacers is at least the length of the inner circumference of the crucible. In one embodiment, the spacer(s) extend from the bottom of the crucible to at least the top of the silicon powder charge.

The spacer may have a thickness operable to prevent the top portion of the silicon powder charge from contacting the crucible sidewall once the spacer is removed from the crucible. In one embodiment, the spacer is at least about 10 mm thick and, in another embodiment, at least about 20 mm thick. The spacer may be inserted and removed from the crucible in any manner as long as a gap is formed between the silicon powder charge and the crucible sidewall at the surface of the charge. In one embodiment, the top of the spacer is exposed after the full charge of silicon powder has been added to the crucible so that the spacer may easily be removed, i.e., the silicon powder has a height at the sidewall which is not greater than the height of the top of the spacer at the moment before the spacer is removed from the crucible.

In one embodiment, silicon powder is partially loaded into the crucible to form a partial silicon charge before the spacer is inserted along the crucible sidewall. After the removable spacer is inserted, the remainder of the silicon powder is then loaded into the crucible to form a complete silicon charge. As more fully described below, the silicon powder may be compacted before the spacer is removed.

Crucibles suitable for use in accordance with the present invention may be constructed of a number of conventional materials including fused or sintered quartz. The crucibles may also be surface-treated as disclosed, for example, in U.S. Patent No. 5,976,247, the entire contents of which are incorporated by reference herein for all relevant and consistent purposes. In one embodiment, the crucible comprises a bottom and a sidewall with an inner surface and the spacer is inserted into the crucible along the inner surface of the sidewall.

Once silicon powder is added to the crucible, the volume of the silicon powder may be reduced by compacting it. Alternatively, the silicon powder can be compacted prior to addition to the crucible. It has been found that the volume of the silicon powder may be reduced by about forty percent by drawing a vacuum in the powder and then inducing a compacting pressure force. The density of the powder can be increased from about 0.7 to about 0.9 g/cm³ to about 1.2 to about 1.6 g/cm³ under this method. The compacting pressure force may be generated by ultrasound, vibration, or gas pressure.

In one embodiment, about 70 torr to about 1 mtorr of absolute pressure is applied to the powder (i.e., a vacuum is applied). In this regard it should be noted that all references to an amount of pressure or vacuum in the present disclosure refer to application of an absolute pressure unless indicated otherwise. The compacting force is then applied to the powder by, for example, inducing a sudden positive pressure to the powder through a baffle disc plate. The baffle disc plate deflects the sudden pressure from directly hitting the powder. The pressure condenses the powder by driving the silicon powder particulates into the voids depleted of air or other previously trapped gas. The silicon powder may be compacted in the crucible or prior to addition to the crucible. If the silicon powder is compacted in the crucible, the removable spacer may be inserted into the crucible before compaction. Optionally, additional silicon powder may be added followed by additional compaction to maximize the amount of silicon powder charged to the crucible. After the final compaction is complete, the spacer may be removed to form a gap between the silicon powder and the crucible sidewall.

In one embodiment, the silicon powder is shaped into a dome prior to compaction to maximize the amount of powder charged to the crucible. However, as illustrated in Example 5 below, powder compacted without being first shaped into a dome stays taller and flatter in the crucible than powder that is shaped into a dome prior to compaction.

In some embodiments, one or more holes extending at least a portion of the distance and, in one embodiment, the entire distance from the surface of the charge toward the bottom of the crucible are formed within the charge. The holes may be formed by inserting a rod or dowel into the powder and removing the rod or dowel from the powder. The holes help silicon oxide escape from the charge during a silicon oxide removal step described more fully below. The number of holes, the diameter of the holes and the distance the holes extend from the surface of the charge towards the crucible may be varied without departing from the scope of the present invention. The holes may be backfilled with granular polysilicon or may be left open.

After the silicon powder charge is prepared in the crucible, the crucible may be loaded onto a silicon ingot puller and the puller may be sealed. The crucible may be covered in plastic or a fitted crucible cover may be used during transfer to prevent release of powder into the ambient to minimize exposure of personnel to airborne powder.

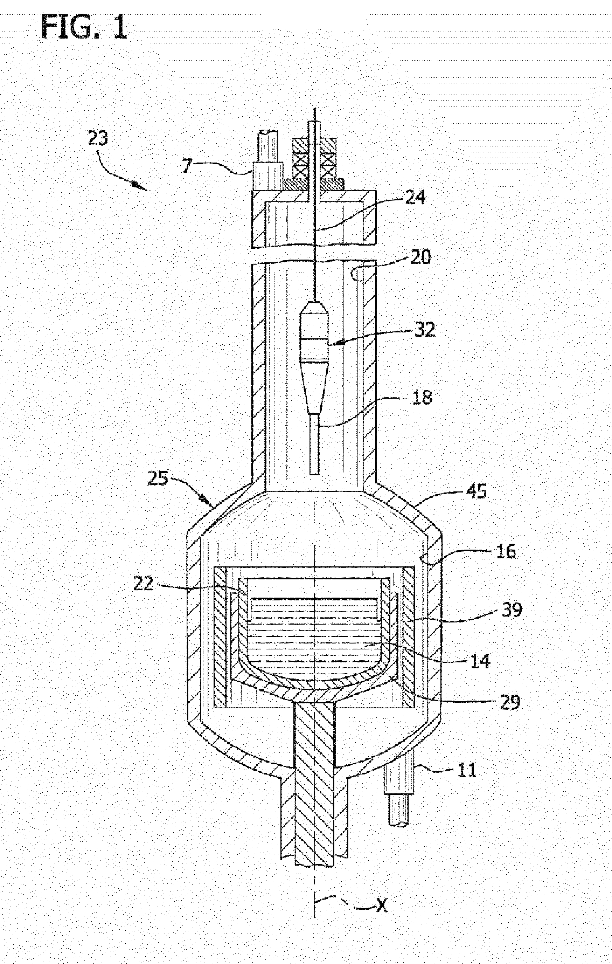

Referring now to the drawings and in particular to Figure 1, a crystal puller for use in accordance with the methods of the present invention of the type used to grow a monocrystalline or polycrystalline silicon ingot according to the Czochralski method is designated by the reference numeral 23. The crystal puller 23 includes a housing 25 that defines a crystal growth chamber 16 and a pull chamber 20 having a smaller transverse dimension than the growth chamber. The growth chamber 16 has a generally dome shaped upper wall 45 transitioning from the growth chamber 16 to the narrowed pull chamber 20. The crystal puller 23 includes an inlet port 7 and an outlet port 11 which may be used to introduce and remove selective ambients to and from the housing 25 during crystal growth.

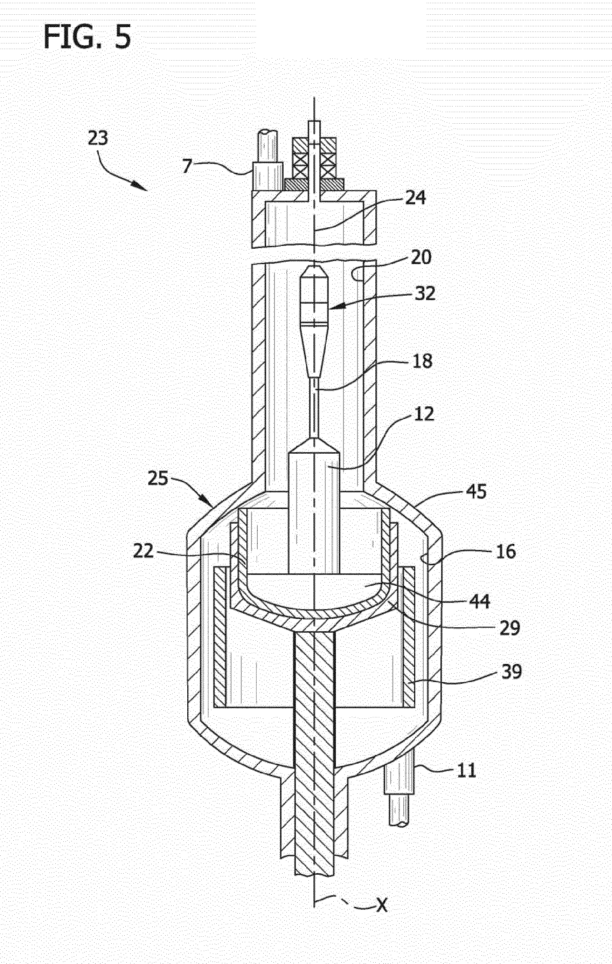

A crucible 22 within the crystal puller 23 contains a silicon charge 14. The silicon charge 14 is shown with gaps at the crucible 22 sidewall. Referring now to Figure 5, the silicon charge is melted to form a silicon melt 44 from which a monocrystalline or polycrystalline silicon ingot 12 is grown. The crucible 22 is mounted on a turntable 29 for rotation of the crucible about a central longitudinal axis X of the crystal puller 23. The crucible 22 is also capable of being raised within the growth chamber 16 to maintain the surface of the melt 44 at a generally constant level as the ingot 12 is grown. An electrical resistance heater 39 surrounds the crucible 22 for melting the silicon powder charge 14 in the crucible. The heater 39 is controlled by an external control system (not shown) so that the temperature of the melt 44 is precisely controlled throughout the pulling process. Insulation (not shown) surrounding the heater 39 may reduce the amount of heat lost through the housing 25. The crystal puller 23 may also include a heat shield assembly (not shown) above the melt surface for shielding the ingot 12 from the heat of the crucible 22 to increase the axial temperature gradient at the solid-melt interface as more fully described, for example, in U.S. Patent No. 6,797,062, the entire contents of which are incorporated herein by reference for all relevant and consistent purposes.

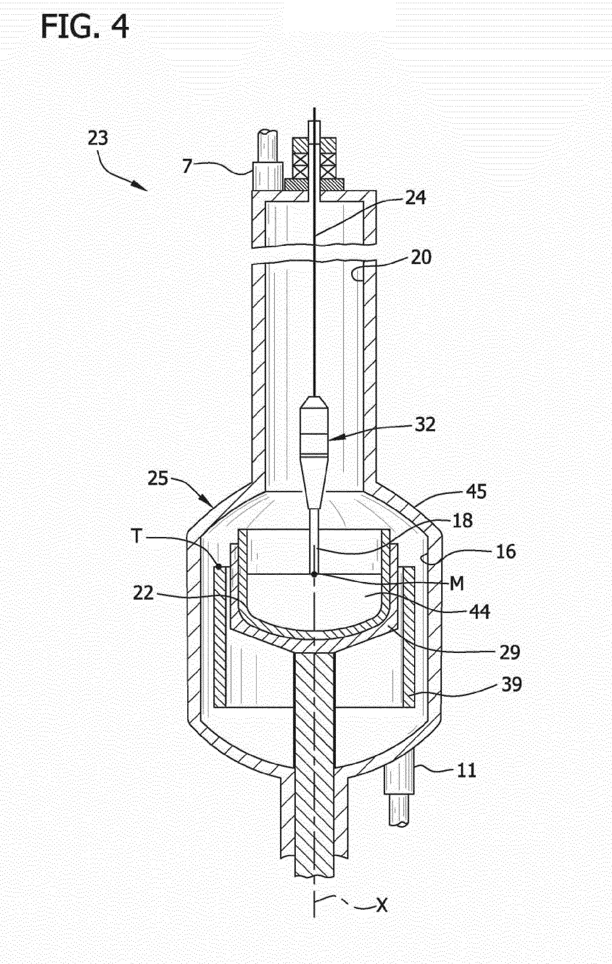

A pulling mechanism (not shown) is attached to a pull wire 24 that extends down from the mechanism. The mechanism is capable of raising and lowering the pull wire 24. The crystal puller 23 may have a pull shaft rather than a wire, depending upon the type of puller. The pull wire 24 terminates in a seed crystal chuck 32 which holds a seed crystal 18 used to grow the monocrystalline or polysilicon ingot 12. In growing the ingot 12, the pulling mechanism lowers the seed crystal 18 until it contacts the surface M of the molten silicon 44 (Fig. 4). Once the seed crystal 18 begins to melt, the pulling mechanism slowly raises the seed crystal up through the growth chamber 16 and pull chamber 20 to grow the monocrystalline or polycrystalline ingot 12 (Fig. 5). The speed at which the pulling mechanism rotates the seed crystal 12 and the speed at which the pulling mechanism raises the seed crystal (i.e., the pull rate v) are controlled by the external control system.

The above described crystal pulling mechanism is provided for illustrative purposes depicting one type of Czochralski type crystal grower. Other types of Czochralski crystal pullers or even other types of crystal growing, such as those used to prepare direct solidification multicrystals such as, for example, as described in U.S. Patent No. 6,378,835, may be used in one or more embodiments of the present invention.

### Removal of Air or Other Oxidizers from the Charge

Once the charge 14 of silicon powder and the crucible 22 are loaded into the single crystal silicon ingot puller 23 and the puller has been sealed, any air and/or other oxidizing gases within the charge may be removed and displaced by an inert gas such as, for example, argon. If air or other oxidizing gases are not removed, silicon oxides can become incorporated within the silicon melt and, as a result, into the growing silicon ingot causing structural defects to form within the ingot. Additionally or alternatively, if large oxides adhere to the outside of the ingot, ingot removal or automated diameter control may become difficult.

The ambient within the housing 25 of the crystal puller 23 may be removed by applying a vacuum to the housing. A vacuum may be applied by sealing the inlet port 7 and applying a vacuum to the outlet port 11. A vacuum may be applied by any of the well known methods in the art including, for example, by use of a vacuum pump. The vacuum pump pulls the ambient within the silicon powder charge 14 from the charge and towards the pump.

It has been found that once a vacuum is applied in the housing, silicon powder in the silicon powder charge 14 can become entrained in the ambient pulled from the charge. Entrained silicon powder flows through the gas outlet 11 and can damage the vacuum pump and can plug process lines. Further, the vacuum can cause the silicon charge to become unpacked. According to one process of the present invention, the rate of removal of the ambient within the housing 25 is controlled to prevent silicon powder from becoming entrained in the ambient. In one embodiment, a portion of the ambient is removed to create a vacuum of less than about 300 torr of absolute pressure in the housing 25, wherein the rate of removal of the ambient is controlled to prevent silicon powder from becoming entrained in the ambient. In another embodiment, a portion of the ambient is removed to create a vacuum of less than about 250 torr of absolute pressure in the housing, wherein the rate of removal of the ambient is controlled to prevent silicon powder from becoming entrained in the ambient.

For example, if the pressure within the housing 25 before the vacuum is applied is about atmospheric, removal of the ambient may be controlled such that the period of time the pressure in the housing changes from about atmospheric to about 300 torr is at least about 60 seconds. Removal of the ambient within the housing 25 may be controlled by any method known in the art including, for example, use of a controller that controls the amount of vacuum generated by the vacuum pump or by use of a controller that controls the position of a valve located between the source of vacuum and the housing 25. Alternatively, the valve output may be controlled manually. In one embodiment, control of the vacuum applied to the housing 25 is regulated by use of a throttled process pipe that has a diameter sufficiently small to create significant drag between the escaping ambient and the pipe such that the desired vacuum pressure is achieved gradually. In some embodiments, removal of the ambient is controlled such that the period of time the pressure in the housing changes from about atmospheric to about 300 torr is at least about 90 seconds and in some embodiments at least about 120 seconds. In one embodiment, during the period of time the pressure in the housing changes from about atmospheric to about 300 torr, the rate at which the vacuum is applied is controlled to be less than about 4 torr per second and, in other embodiments, less than about 3 torr per second and even less than about 2 torr per second.

In one embodiment, removal of the ambient is controlled such that the period of time the pressure in the housing changes from about atmospheric to about 250 torr may be at least about 60 seconds, in another embodiment, at least about 90 seconds and even at least about 120 seconds. In one embodiment, during the period of time the pressure in the housing changes from about atmospheric to about 250 torr, the rate at which the vacuum is applied may be controlled to be less than about 4 torr per second and, in other embodiments, less than about 3 torr per second and even less than about 2 torr per second.

By controlling the amount of vacuum applied to the housing 25 of the crystal puller 23, entrainment of silicon powder into the ambient as the ambient is removed may be prevented. In one embodiment, the absolute pressure of about 300 torr or about 250 torr is an intermediate vacuum and further vacuum is applied after the intermediate vacuum is reached. Once the intermediate vacuum of about 300 torr or about 250 torr of absolute pressure is reached, a final vacuum of less than about 5 torr of absolute pressure may be applied. It has been found that during the transition from about intermediate vacuum to the final vacuum of about 5 torr of absolute pressure, silicon powder does not become entrained in the ambient escaping the housing 25. Accordingly, it is not necessary to control the rate at which the final vacuum of less than about 5 torr of absolute pressure is applied. Once an intermediate vacuum of about 300 torr of absolute pressure is applied, a sufficient amount of air or other oxidizing gas has been removed from the silicon powder charge and an inert gas such as argon may be introduced into the housing 25. In some embodiments, a final absolute pressure of less than about 1 torr is applied to the housing. Other inert gases may be used beside or in addition to argon including, for example, hydrogen. The crucible and silicon charge may be rotated while the vacuum is applied to establish a uniform vacuum throughout the charge.

### Removal of Silicon Oxides

It has been found that silicon oxides on the surface of the silicon powder particles should be removed to prevent the silicon oxides from agglomerating and interfering with the solid-melt interface during ingot growth. According to one process of the present invention, the silicon oxides are removed by heating the silicon charge to a temperature from about 1100°C to a temperature less than the melting temperature of the silicon charge for at least about 30 minutes, for at least about 1 hour or even for at least about 2 hours. The duration of the heat treatment to remove the silicon oxides may be varied depending on the amount of oxides present and the temperature to which the silicon powder is heated. In the case where the melt is based on silicon powder collected from a fluidized bed reactor utilized in the chemical vapor deposition of silicon from a thermally decomposable compound, silicon oxides are sufficiently removed from the charge after the charge has been heated for about 30 minutes. The crucible and silicon charge may be rotated while the silicon charge is heated to establish a uniform thermal field.

By pre-heating the charge, an amount of silicon oxide at the surface of the powder particles may be removed from the charge and an oxide depleted silicon charge is formed. During this step, hydrogen, an inert gas such as argon or mixture thereof may be introduced into the housing 25 through the inlet port 7 and gas is withdrawn through the outlet port 11. If argon or another inert gas is used, some of the silicon oxides at the surface of the silicon powder particles sublime and are removed as silicon monoxide gas. If hydrogen is used, the hydrogen gas reacts with the silicon oxide to form water vapor that may be removed from the outlet port 11. In one embodiment, hydrogen is used as an oxide removal gas because it readily reacts with the oxides thus removing the oxides from the charge rapidly as compared to argon. However, hydrogen may pose a safety risk in many crystal growth facilities due to its combustible nature and an inert gas may suitably be used.

The hydrogen or inert gas may be introduced into the housing at various rates, however, in one embodiment, is introduced at a rate of at least about 20 standard liters per minute.

The pressure within the housing 25 may be maintained at a vacuum from about 30 torr to about 1 torr of absolute pressure while the oxides are removed. In some embodiments, the pressure within the housing 25 is cycled to help displace sublimed oxides within the charge with an inert gas or hydrogen. By cycling the amount of vacuum in the housing 25, the oxides are pulled from the powder charge rather than kept at the cold upper surface of the charge. In some embodiments, the pressure within the housing is substantially constant during oxide removal.

In some embodiments, at least about 95% of the oxides are removed from the silicon charge and, in other embodiments, at least about 98% and, in some embodiments, even at least about 99% of the oxides are removed from the silicon charge. After the oxide depleted silicon charge is prepared, the oxide depleted silicon charge may be heated to a temperature above the melting temperature of the charge to prepare the melt.

### Meltdown of the Silicon Powder Charge

The silicon charge may be melted by heating the silicon powder to a temperature above the melting temperature of the charge, typically to at least about 1412°C. The charge should not be heated to a temperature at which the crucible may become damaged, i.e., typically the charge is heated to a temperature from about 1412°C to about 1575°C.

Referring now to Figure 1, the heater 39 utilized to melt the charge 14 is in thermal communication with the crucible 22 such that the crucible may be heated to a temperature sufficient to melt the silicon charge. The heater 14 has a top and a bottom that defines a heater length and an axial centerpoint midway between the top and the bottom of the heater. As used herein, the length of the heater is typically the portion of the heater where most of the power is radiated. In conventional heaters, the portion of the heater where most of the power radiated is a serpentine portion. An example of a heater with a serpentine portion is shown in U.S. Patent No. 6,093,913, the entire contents of which are incorporated herein by reference for all relevant and consistent purposes. In some embodiments, the length of the heater is at least about 300 mm and, in other embodiments, at least about 400 mm. The charge 14 has a surface, bottom and an axial centerpoint C midway between the surface and bottom of the charge.

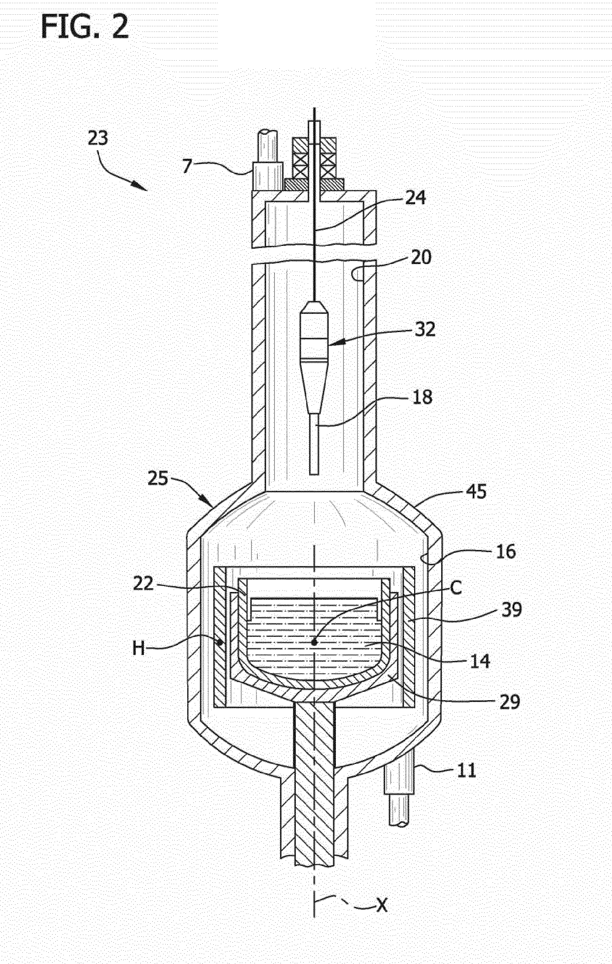

Referring now to Figure 2, during meltdown the crucible 22 is held at a first axial position wherein the distance between the axial centerpoint C of the charge 14 and the axial centerpoint H of the heater 39 may be less than about 15% of the heater length. This allows the heat emanating from the heater 39 to be concentrated at the center of the charge 14. At this position a sufficient amount of heat is concentrated toward the top portion of the charge such that the melting charge does not form a column and cap of silicon powder which can potentially collapse and break the crucible. Rather, the remaining unmelted silicon charge gradually sinks or slips into the melt below it. Further, by maintaining the crucible 22 at a position wherein the distance between the axial centerpoint C of the charge 14 and the axial centerpoint H of the heater 39 is less than about 15% of the heater length, the top portion of the charge acts as an insulator and prevents excessive heat loss as an excessive amount of heat is not concentrated towards the top portion of the charge.

Depending on the size and initial temperature of the charge 14 and the power output of the resistance heater 39, it may take at least about 2 hours to melt the charge. The output of the resistance heater may be controlled such that the charge is not melted in less than about 2 hours and, in one embodiment, is not melted in less than about 4 hours to provide more time to ensure any remaining oxides in the powder are dissolved and/or evaporated from the melt. The crucible 22 and the melting silicon charge 14 may be rotated while the silicon charge is heated to establish a uniform thermal field and to establish a uniform melt.

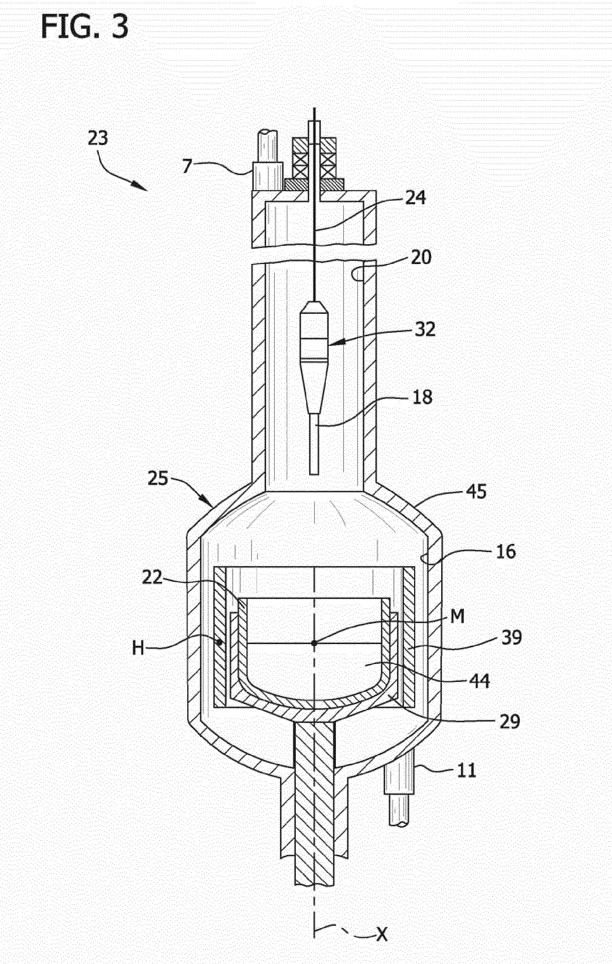

Referring now to Figure 3, once the charge 14 has been melted, the crucible 22 is positioned at a second axial position wherein the distance between the surface M of the melt 44 and the axial centerpoint H of the heater 39 is less than about 15% of the heater length and the temperature of the silicon melt is maintained above the melting temperature of the charge at the second axial position for at least about 30 minutes. This step allows most silicon oxides which have agglomerated as solids to dissolve into the liquid and evaporate. In some embodiments, the distance between the between the surface M of the melt 44 and the axial centerpoint H of the heater 39 is less than about 15% of the heater length while the temperature of the silicon melt is maintained above the melting temperature of the charge at the second axial position for at least about 1 hour, and in some embodiments for at least about 2 hours or more. Typically the silicon melt is not maintained above about 1575°C at the second axial position to prevent the crucible from being thermally damaged.

The volume of the silicon melt 44 is typically less than the volume of the charge of silicon powder 14 used to prepare the melt due to the voids between the silicon powder particles in the silicon powder charge. In some embodiments, the volume of the silicon melt 44 is about 25% less than the volume of the silicon charge 14 used to prepare the melt and, in some embodiments, less than about 40% and even less than about 50%. Accordingly, the surface M of the melt 44 relative to the crucible 22 is lower than the surface of the silicon powder charge 14 relative to the crucible. In some embodiments, the position of the surface M of the melt 44 relative to the crucible 22 is near the position of the axial centerpoint C of the charge 14 relative to the crucible 22 before melting of the charge. Accordingly, in some embodiments, the crucible does not have to be lowered from the first axial position to position the crucible at the second axial position. In some embodiments, the difference in position between the first axial position and the second axial position is less than about 5% of the heater length and, in some embodiments, the first axial position and the second axial position are substantially the same.

Once the melt 44 has been maintained at the temperature above the melting temperature of the charge at the second axial position for at least about 30 minutes, the crucible may be raised to a third axial position proper for the start of the crystal pull process. In one embodiment, the third axial position of the crucible during the start of the crystal pull process is substantially the same as the first axial position of the meltdown process. In one embodiment and as shown in Figure 4, the surface M of the melt 44 is from about 2.5% to about 25% of the heater length below the top T of the heater 39 during the start of the crystal pull process. This melt position helps ensure that the surface of the melt is exposed to the radiant heat of the heater so as to prevent solidification of silicon at the melt surface. Once the crucible 22 is positioned at the third axial position, the seed 18 of the pulling mechanism is lowered to the surface M of the melt and raised to pull an ingot from the silicon melt.

### Pulling of the Silicon Ingot

The various features of the present invention, that is, for example, use of a removable spacer between the crucible sidewall and the silicon powder charge; application of vacuum to remove air and other oxidizing gases; heating the powder to remove oxides; and controlling the position of the charge relative to the heater during and after melting, may be used alone or in any combination. For instance, use of a removable spacer in the crucible may be combined with application of a vacuum and/or removal of oxides by heating and/or controlling the position of the crucible during and after melting; application of the vacuum may be combined with use of a removable spacer and/or removal of oxides by heating and/or controlling the position of the crucible during and after melting; removal of oxides by heating may be combined with use of a removable spacer and/or application of vacuum and/or controlling the position of the crucible during and after melting; and controlling the position of the crucible during and after melting may be combined with use of a removable spacer and/or application of a vacuum and/or removal of oxides by heating.

The melt 44 produced by one or more of the above methods may suitably be utilized in the crystal puller 23 to prepare a single crystal silicon ingot or a polycrystalline silicon ingot by the Czochralski method. Crystal growth conditions for producing single crystal silicon or polycrystalline silicon are conventional and well known in the art. The crucible 22, the silicon melt 44 and the growing silicon ingot 12 may be rotated while the crystal is pulled to establish a uniform thermal field within the melt and the growing ingot.

It is important to remove most of the oxides in the charge if single crystal silicon is desired so that single crystal growth conditions may be maintained during pulling of the silicon ingot. In some embodiments, at least about 95% of the oxides are removed prior to single crystal silicon growth and, in other embodiments, at least about 98% and, in some embodiments, even at least about 99% of the oxides are removed prior to single crystal silicon growth.

If a polycrystalline silicon ingot is intentionally or unintentionally drawn from the silicon melt, the polysilicon ingot may be broken into smaller pieces or "chunks.. The polysilicon chunks may be introduced into a direct solidification furnace to produce multicrystalline silicon or introduced into a crucible and melted within a crystal puller for production of a single crystal silicon ingot.

### Examples

### Example 1: Preparation of a silicon ingot from a melt of silicon powder and recycled wafers

This example illustrates application of a gradual vacuum in a single crystal silicon puller and illustrates the need for oxide removal prior to meltdown.

A new valve was installed on a crystal puller (Hamco CG2000 R/C-30 with a heater length of about 355 mm) to limit the rate at which the vacuum was applied to limit loss of powder. With a nearly closed vacuum valve and a slight flow of argon (-5 SCFM) the pumpdown rate was limited to 1.5 minutes for the first 10 pounds of vacuum (~1/3 atmosphere). Argon flow was adjusted downwards to allow continued pump down, and low pressures (50 mtorr) were eventually reached by fully opening the vacuum valve and stopping the argon flow. After full pumpdown, the pump solenoid valve and manual throttle valve were closed and a filter canister bleed valve opened to backfill and oxidize the filter. The filter was removed to verify powder was not removed from the crucible during pumpdown and another new filter was installed.

Two GE (Momentive) fused crucibles were charged with about 17 kg of powder each, and were topped with about 1 kg of P- recycle wafers as heat reflectors. The total weight was 26 kg for each charge and the distance from the top of the wafers to the top of the crucible was 0.5" in one case and 1" in the other. A plastic cover and rubber band was restored to the top of the crucible after filling to limit exposure to powder.

To install the crucible into the crystal puller, the crucible was placed into one susceptor half, leaned, then the other susceptor half was slid under the crucible. The susceptor halves were clamped closed with a wide plastic tie, then lifted together into the furnace. After installation, it was noticed that the gap between the heater and susceptor was small (approaching 1/8") due to heater distortion (104 runs). The alignment between the crucible and susceptor was manipulated to reduce risk of arcing to the heater.

Even with close scrutiny, no evidence of powder movement was observed throughout the pump down phase. In addition, when the pump down filter was removed, it appeared quite clean, with no silicon powder obvious on the surface.

The procedure for meltdown is shown in Table 1 below. The "crucible position" is in inches of vertical travel, with zero the point where the top of the crucible is level with the top of the heater.

**Table 1: Crystal puller parameters used during the silicon powder charge meltdown of Example 1.**

| Time (min) | Heater Power (KW) | Puller Pressure (torr) | Argon Flow Rate (SCFM) | Crucible Position (in) | Observations |
|---|---|---|---|---|---|
| 0 | 102 | 16 | 40-50 | 2.5 | Heater Fired |
| 4 | 97.7 | | | 2.11 | Powder was stable and appeared to |
| 34 | | | | | Bright glow and 1/8" downward movement of powder |
| 44 | 97.7 | | | 1.87 | Small sparkles appeared at the edge of the crucible and ¼" downward movement of powder; cracks appeared at surface of powder; powder appeared beaded at crucible wall |
| 60 | 97.5 | | | 0.98 | 1" downward movement; surface of crust appeared hot; surface of powder about ½" above top of heater |
| 69 | 97.5 | | | 0.55 | Top of crust very bright; oxide ring formed on the wall above powder; wafers appeared hot |
| 85 | 97.3 | 24 | 60 | -0.36 | 5" downward movement of powder; considerable oxide smoking |
| 91 | 93.7 | | | -0.59 | First liquid became visible; center island began to tip; oxide pieces fell off crucible wall into melt |
| 93 | 97.3 | | | -0.69 | Wafers were in the melt |
| 103 | 97.3 | 18 | 40 | -1.23 | Oxide Fuming |
| 134 | | | | | Meltdown complete; oxides formed a cup shape and attached to the bottom of the crucible |

After meltdown, the crucible was raised to heat the bottom of the crucible to release oxides from the crucible bottom. These floating oxides were frozen to the seed and removed. During ingot growth, oxide particles continued to surface and hit the seed and growing taper. Throughout the crown and body, pieces of oxide would surface and hit the crystal. Silicon solidified at the crucible wall due to low thermal gradients and an available oxide nucleation point and the crystal was popped free of the melt. The crystal diameter was very close to 6" (6.07" measured); however, at a large oxide protrusion, the radius was increased by 0.67". This flat ledge would have an equivalent crystal diameter of 7.41", and is thought to have caught in the throat as the crystal was being raised, breaking the seed. The short crystal fell onto the frozen melt surface in a vertical orientation.

In view of the excessive oxide formation, oxides should be removed prior to meltdown of the silicon powder by, for example, heating the charge to a temperature from about 1100°C to the melting temperature of the silicon charge in cases where oxides are substantially present prior to melt down.

### Example 2: Preparation of a silicon ingot from a melt of silicon powder

This example illustrates how a rapid pumpdown may cause silicon powder to become entrained in the escaping gas and illustrates the need for procedures that prevent formation of a bridge of powder across the crucible.

A GE (Momentive) fused crucible was charged with about 17 kg of powder and was installed into a susceptor. Holes were formed by removing powder from the center and four quadrant locations and 700 g of granular polysilicon was used to back-fill the holes. The granular polysilicon was tamped into place several times. It was believed that the granular polysilicon would operate as a vent for oxides to escape during meltdown.

The powder was 1/2" below the top of the crucible after charging and before application of vacuum. Vacuum was applied rapidly to the crystal puller to test the need for the manual valve used in Example 1. The crucible began to overflow during the rapid pumpdown as gas in pockets between the powder particles expanded faster than the gas could escape from the space. The entire charge rose uniformly and pumpdown was halted to prevent continued overflow. During the initial fast pumpdown, the granular polysilicon dropped to several inches below the powder surface at several of the holes which indicated that the open holes were effective in allowing ventilation of oxide. After cleanup, a gradual pumpdown as in Example 1 was performed. The crucible did not overflow.

The meltdown procedure is shown in Table 2 below. In this example, the pressure was changed several times during the initial heatup and pumpdown by argon flow changes to more effectively exchange oxidation gasses with the puller ambient gas.

**Table 2: Crystal puller parameters used during the silicon powder charge meltdown of Example 2.**

| Time (min) | Heater Power (kw) | Puller Pressure (torr) | Argon Flow Rate (slpm) | Crucible Position (in) | Heater Temp. (°C) | Crucible Temp. (°C) | Observations |
|---|---|---|---|---|---|---|---|
| 0 | 60 | 0 | 0 | 2.5 | | | Fired Puller |
| 5 | 60 | 0 | 0 | 2.5 | 770 | | |
| 9 | 60 | 0 | 0 | 1.9 | 850 | | |
| 13 | 60 | 2 | 8 | 1.73 | 930 | | |
| 18 | 60 | 4 | 8 | 1.6 | 1050 | 730 | |
| 23 | 60 | 4 | 8 | 0 | | | |
| 25 | 60 | 3.8 | 8 | -0.2 | 1145 | 880 | Brief heater arcing |
| 31 | 60 | 20 | 50 | -0.25 | 1260 | 940 | |
| 43 | 60 | 21 | 50 | -1.5 | 1350 | 1050 | Bit lower? |
| 46 | 60 | 4.3 | 8 | -1.4 | 1400 | 1120 | Change pressure |
| 62 | 60 | 21 | 50 | -1.47 | 1440 | 1200 | |
| 77 | 60 | 4.2 | 8 | -1 | 1450 | 1230 | Cracks in pack |
| 93 | 60 | 21 | 50 | -1.84 | 1489 | 1195 | |
| 103 | 65 | 21 | 50 | -1.5 | | | Increased SH Power |
| 109 | 65 | 4.2 | 8 | -1.6 | 1508 | 1210 | Small oxide visible, port and above powder pack |
| 123 | 65 | 4.2 | 8 | -1.4 | 1532 | 1209 | |
| 135 | 65 | 21 | 50 | -1.4 | 1548 | 1211 | Hole visible through BB tube |
| 143 | 70 | 21 | 50 | -2.5 | | | |
| 149 | 70 | 4.3 | 8 | -2.43 | 1574 | 1251 | Crack/hole in center, crust glow (2 places) |
| 164 | 70 | 21 | 50 | -2.43 | 1550 | 1275 | 1 hole closing w/oxide rings |
| 169 | 90 | 21 | 50 | -2.43 | | | Multiple holes closing w/oxide |
| 180 | 90 | 21 | 50 | -2.78 | | | Bright spots in crust |
| 187 | 90 | 21 | 50 | -2.78 | | | Lowered seed to touch, barely friable, knocked several grains off |
| 191 | 97 | 21 | 50 | -2.78 | | | |
| 204 | 97 | 21 | 50 | -2.78 | | | Thick powder bridge, liquid visible beneath |
| 243 | 105 | 21 | 50 | -2.78 | | | |
| 254 | 105 | 21 | 50 | -2.78 | | | Top crust fell in |

At one point in the meltdown the entire surface of the powder bridge (with only liquid beneath) appeared to have been sealed by powder sintering plus oxide deposition. The surface of this powder bridge appeared very solid and did not break after contact with a seed crystal. The bridge was collapsed by stopping the rotation of the crucible, installing a taper on the seed and increasing the power output of the heater to 105 kw. This procedure allowed the oxide to be burned away from the wall for about a quarter of a revolution along the crucible edge and caused the bridge to collapse into the melt.

After another hour of meltdown, baking was required to remove the oxides from the melt surface. After the meltdown was complete, no oxides were visible at the melt surface and no oxides visibly surfaced during crystal growth. An oxide rim remained at the top of the crucible. Two neck attempts were made, attempting zero dislocation growth, with the second attempt loosing late crown. The polycrystal diameter was controlled during growth using normal furnace automation.

Use of a removable spacer to create a gap between the charge would have prevented the formation of a bridge across the crucible. Controlling the position of the crucible during meltdown and maintaining the charge temperature above the melting temperature of the charge for at least about 30 minutes would have reduced oxide formation.

### Example 3: Preparation of a silicon ingot from a melt of silicon powder with a lower crucible position

This example illustrates the use of a lower crucible position to minimize silicon powder bridge formation.

A crucible (SEH) was loaded with 17.2 kg of powder. Holes and an irregular surface were generated in the top of the charge to weaken the structural integrity of any powder bridge. A throttle valve was used to limit pumpdown rate for most of the pumping cycles.

No pressure changes were generated to determine the effect of this variable on oxide stability. The crucible was lower than the crucible in Example 2 for most of the oxide removal stage. A quartz reflector with molybdenum at the bottom surface of the reflector facing the powder charge was suspended from the seed chuck to increase the powder top temperature to test the reflector's ability to limit oxide levels. The reflector represented about 18% of the powder top surface. A reduced side heater power of 65 kw was used to improve oxide removal.

No oxide was visible on the melt before the thin powder bridge fell in. With a higher furnace pressure (40-50 torr of absolute pressure instead of 20-30 torr of absolute pressure), the oxide could not be fully dissolved and was dipped out prior to crystal growth. An 11.4 kg ingot was grown from the 17.2 kg powder charge before removal of the ingot from the melt due to solidified silicon at the crucible wall.

Use of a removable spacer to create a gap between the charge would have prevented the formation of a bridge across the crucible. Controlling the position of the crucible during meltdown and maintaining the charge temperature above the melting temperature of the charge for at least about 30 minutes would have reduced oxide formation.

### Example 4: Preparation of a silicon ingot from a melt of silicon Powder bricks

This example illustrates meltdown of silicon powder bricks and illustrates the effect of a higher crucible position during meltdown.

A few months before the trial, water (~20% by volume) was mixed with powder in a bucket (5 gallon) to form a paste. The paste was placed in a rubberized cake pan and the cake pan inverted onto plastic. The formed bricks were then air-dried underneath plastic sheeting for several months.

A total of 17.2 kg of powder bricks were initially charged to a fully-coated crucible (SEH). Some brick were broken for better stacking. A larger charge would have been possible if more bricks had been available.

Pumpdown was done step-wise (pump to -5" Hg vacuum, wait 2 minutes, pump to -10" Hg vacuum, wait 2 minutes, pump to -20" Hg vacuum, wait 2 minutes, then pump to -28" Hg vacuum). No brick expansion, damage or loss was observed using this method. No pressure changes were generated during the meltdown. The crucible was higher than the crucible in Example 2 for most of the oxide removal stage. A side heater power of 65 kw was used to improve oxide removal.

In this experiment, oxide formation on the crucible wall was observed. These oxides fell into the melt during the high power stage of the meltdown and formed a floating raft. The oxide levels were similar to the first powder meltdown performed. It is believed that the higher furnace pressure (40-80 torr of absolute pressure instead of 20-30 torr of absolute pressure), prevented the oxides from being fully dissolved; the oxides were dipped out prior to crystal growth. Due to gaps between the bricks and the crucible wall that allowed oxides to escape during the meltdown, no bridge formed during meltdown.

An 11.1 kg ingot was grown from a 17.2 kg powder charge (64.5%) before removal from the melt due to oxide and solidification of silicon.

It should be noted that maintaining the charge temperature above the melting temperature of the charge for at least about 30 minutes before ingot growth would have reduced oxide formation.

### Example 5: Comparison of compaction of silicon powder with and without dome shaping

This example illustrates the use of powder compaction. Silicon powder was added to a crucible, shaped in a dome and compacted. Silicon powder was added to a second crucible but was not shaped into a dome prior to compaction. The powder compacted without being first shaped into a dome stayed taller and flatter in the crucible than the powder that was shaped into a dome prior to compaction.

### Example 6: Preparation of a silicon ingot from a melt of silicon Powder with use of compaction and a removable spacer

This example illustrates how formation of a gap between the crucible sidewall and the powder can eliminate powder bridge formation.

Four crucibles were partly filled with silicon powder and rubber foam spacers were inserted into the crucibles along the entire circumference of the crucible sidewalls. Additional silicon powder was added to the crucibles and each silicon charge was compacted. After compaction, the heights of the charges along the crucible sidewalls were less than the tops of the spacers. The spacers were then removed from the crucibles.

Each silicon powder charge was melted with a high argon gas flow (100 slpm) in a furnace (Leybold EKZ 2000 with a heater length of about 432 mm). Meltdowns were shorter than previous meltdowns due to greater hotzone efficiency and the use of a gap between the charge and the crucible. None of the meltdowns required oxide removal as the gap acted as an exit route for the silicon oxides. Three 15" ingots were formed (23.3 kg; 23.1 kg; 21.4 kg) with polysilicon yields of 94%, 93% and 86% respectfully. An 18" ingot was formed (37.5 kg) with a 78% yield.

When introducing elements of the present invention or the preferred embodiments(s) thereof, the articles "a", "an", "the" and "said" are intended to mean that there are one or more of the elements. The terms "comprising", "including" and "having" are intended to be inclusive and mean that there may be additional elements other than the listed elements.

As various changes could be made in the above apparatus and methods without departing from the scope of the invention, it is intended that all matter contained in the above description and shown in the accompanying figures shall be interpreted as illustrative and not in a limiting sense.

### FURTHER EMBODIMENTS

1. A process for preparing a melt of silicon powder for use in growing a single crystal or polycrystalline silicon ingot in accordance with the Czochralski method, the silicon powder being loaded into a crucible to form a silicon charge comprising at least about 20% silicon powder by weight, the silicon powder comprising silicon powder particles with an amount of silicon oxide at their surface, the crucible being located within a housing of a crystal puller for pulling the silicon ingot, the process comprising
   heating the silicon charge to a temperature from about 1100°C to a temperature less than about the melting temperature of the silicon charge for at least about 30 minutes to prepare an oxide depleted silicon charge; and
   heating the oxide depleted silicon charge to a temperature above the melting temperature of the charge to form a silicon melt.
2. A process as set forth in item 1 wherein the silicon charge is heated to a temperature from about 1100°C to a temperature less than about the melting temperature of the silicon charge for at least about 1 hour to prepare the oxide depleted silicon charge.
3. A process as set forth in item 1 wherein the silicon charge is heated to a temperature from about 1100°C to a temperature less than about the melting temperature of the silicon charge for at least about 2 hours to prepare the oxide depleted silicon charge.
4. A process as set forth in item 1 wherein the silicon charge is heated to a temperature from about 1100°C to a temperature less than about the melting temperature of the silicon charge for at least about 30 minutes in an ambient comprising argon to prepare the oxide depleted silicon charge.
5. A process as set forth in item 4 wherein argon is fed into the housing to sublime the silicon oxides and produce silicon monoxide gas and argon and silicon monoxide gas are withdrawn from the housing.
6. A process as set forth in item 1 wherein the silicon charge is heated to a temperature from about 1100°C to a temperature less than about the melting temperature of the silicon charge for at least about 30 minutes in an ambient comprising hydrogen to prepare the oxide depleted silicon charge.
7. A process as set forth in item 6 wherein hydrogen is fed into the housing to react with the silicon oxides and produce water vapor and wherein water vapor is withdrawn from the housing.
8. A process as set forth in any one of items 1-7 wherein a vacuum is maintained in the housing of the crystal puller while the silicon charge is heated to a temperature from about 1100°C to a temperature less than about the melting temperature of the silicon charge for at least about 30 minutes to prepare the oxide depleted silicon charge.
9. A process as set forth in item 8 wherein the vacuum is controlled to produce a cyclical vacuum.
10. A process as set forth in any one of items 1-9 wherein the melting temperature of the charge is about 1412°C.
11. A process as set forth in any one of items 1-10 wherein the charge is heated to a temperature from about 1412°C to about 1575°C to melt the oxide depleted silicon charge.
12. A process as set forth in any one of items 1-11 wherein the silicon charge is heated to a temperature from about 1100°C to about 1412°C for at least about 30 minutes to prepare the oxide depleted silicon charge.
13. A process as set forth in any one of items 1-12 wherein the silicon charge comprises silicon powder discharged from a fluidized bed reactor utilized in the chemical vapor deposition of silicon from a thermally decomposable compound.
14. A process as set forth in any one of items 1-13 wherein the silicon charge includes silicon powder with an average nominal diameter of less than about 50 µm.
15. A process as set forth in any one of items 1-14 wherein the silicon charge includes at least about 35% silicon powder by weight.
16. A process as set forth in any one of items 1-14 wherein the silicon charge includes at least about 50% silicon powder by weight.
17. A process as set forth in any one of items 1-14 wherein the silicon charge includes at least about 75% silicon powder by weight.
18. A process as set forth in any one of items 1-14 wherein the silicon charge includes at least about 90% silicon powder by weight.
19. A process as set forth in any one of items 1-14 wherein the silicon charge includes at least about 99% silicon powder by weight.
20. A process as set forth in any one of items 1-14 wherein the silicon charge consists essentially of silicon powder.
21. A process as set forth in any one of items 1-20 wherein a portion of the ambient is removed to create a vacuum in the housing prior to heating the silicon charge to a temperature from about 1100°C to a temperature less than about the melting temperature of the silicon, wherein the rate of removal of the ambient is controlled to prevent silicon powder from becoming entrained in the ambient.
22. A process as set forth in any one of items 1-21 wherein the crucible comprises a sidewall and wherein there is a gap between a portion of the sidewall and the charge prior to heating the silicon charge to a temperature above the melting temperature of the charge to form a silicon melt.
23. A process for preparing a melt of silicon powder for use in growing a single crystal or polycrystalline silicon ingot in accordance with the Czochralski method, the silicon powder being loaded into a crucible to form a silicon charge, the crucible being located within a housing of a crystal puller for pulling the silicon ingot, the housing comprising an ambient, the process comprising
   removing a portion of the ambient to create a vacuum in the housing, wherein the rate of removal of the ambient is controlled to prevent silicon powder from becoming entrained in the ambient; and
   heating the silicon charge to a temperature above the melting temperature of the charge to form a silicon melt.
24. A process as set forth in item 23 wherein a portion of the ambient is removed to create a vacuum of less than about 300 torr of absolute pressure in the housing, wherein the rate of removal of the ambient is controlled to prevent silicon powder from becoming entrained in the ambient.
25. A process as set forth in item 23 wherein a portion of the ambient is removed to create a vacuum of less than about 250 torr of absolute pressure in the housing, wherein the rate of removal of the ambient is controlled to prevent silicon powder from becoming entrained in the ambient.
26. A process as set forth in item 23 wherein the pressure in the housing before the vacuum is applied is about atmospheric.
27. A process as set forth in item 26 wherein the period of time the pressure in the housing changes from about atmospheric to about 300 torr is at least about 60 seconds.
28. A process as set forth in item 26 wherein the period of time the pressure in the housing changes from about atmospheric to about 300 torr is at least about 90 seconds.
29. A process as set forth in item 26 wherein the period of time the pressure in the housing changes from about atmospheric to about 300 torr is at least about 120 seconds.
30. A process as set forth in item 26 wherein the rate of removal of the ambient is controlled to be less than about 4 torr per second while the pressure in the housing changes from about atmospheric to about 300 torr.
31. A process as set forth in item 26 wherein the rate of removal of the ambient is controlled to be less than about 3 torr per second while the pressure in the housing changes from about atmospheric to about 300 torr.
32. A process as set forth in item 26 wherein the rate of removal of the ambient is controlled to be less than about 2 torr per second while the pressure in the housing changes from about atmospheric to about 300 torr.
33. A process as set forth in 26 wherein the period of time the pressure in the housing changes from about atmospheric to about 250 torr is at least about 60 seconds.
34. A process as set forth in item 26 wherein the period of time the pressure in the housing changes from about atmospheric to about 250 torr is at least about 90 seconds.
35. A process as set forth in item 26 wherein the period of time the pressure in the housing changes from about atmospheric to about 250 torr is at least about 120 seconds.
36. A process as set forth in item 26 wherein the rate of removal of the ambient is controlled to be less than about 4 torr per second while the pressure in the housing changes from about atmospheric to about 250 torr.
37. A process as set forth in item 26 wherein the rate of removal of the ambient is controlled to be less than about 3 torr per second while the pressure in the housing changes from about atmospheric to about 250 torr.
38. A process as set forth in item 26 wherein the rate of removal of the ambient is controlled to be less than about 2 torr per second while the pressure in the housing changes from about atmospheric to about 250 torr.
39. A process as set forth in item 26 wherein a portion of the ambient is removed to create a vacuum of less than about 300 torr of absolute pressure in the housing, wherein the rate of removal of the ambient is controlled to prevent silicon powder from becoming entrained in the ambient, and further comprising removing a further portion of the ambient to create a vacuum of less than about 5 torr of absolute pressure.
40. A process as set forth in item 26 wherein a portion of the ambient is removed to create a vacuum of less than about 250 torr of absolute pressure in the housing, wherein the rate of removal of the ambient is controlled to prevent silicon powder from becoming entrained in the ambient, and further comprising removing a further portion of the ambient to create a vacuum of less than about 5 torr of absolute pressure.
41. A process as set forth in any one of items 23-40 wherein the melting temperature of the charge is about 1412°C.
42. A process as set forth in any one of items 23-41 wherein the charge is heated to a temperature from about 1412°C to about 1575°C to melt the charge.
43. A process as set forth in any one of items 23-42 wherein the silicon charge comprises silicon powder discharged from a fluidized bed reactor utilized in the chemical vapor deposition of silicon from a thermally decomposable compound.
44. A process as set forth in any one of items 23-43 wherein the silicon charge includes silicon powder particles with an average nominal diameter of less than about 50 µm.
45. A process as set forth in any one of items 23-44 wherein the silicon charge includes at least about 20% silicon powder by weight.
46. A process as set forth in any one of items 23-44 wherein the silicon charge includes at least about 35% silicon powder by weight.
47. A process as set forth in any one of items 23-44 wherein the silicon charge includes at least about 50% silicon powder by weight.
48. A process as set forth in any one of items 23-44 wherein the silicon charge includes at least about 75% silicon powder by weight.
49. A process as set forth in any one of items 23-44 wherein the silicon charge includes at least about 90% silicon powder by weight.
50. A process as set forth in any one of items 23-44 wherein the silicon charge includes at least about 99% silicon powder by weight.
51. A process as set forth in any one of items 23-44 wherein the silicon charge consists essentially of silicon powder.
52. A process for preparing a melt of silicon powder for use in growing a single crystal or polycrystalline silicon ingot in accordance with the Czochralski method, the silicon powder being loaded into a crucible to form a silicon charge, the crucible being located within a housing of a crystal puller for pulling the silicon ingot, the crystal puller having a heater in thermal communication with the crucible for heating the crucible to a temperature sufficient to melt the silicon charge, the heater having a top and a bottom defining a heater length and an axial centerpoint midway between the top and the bottom of the heater, the crucible capable of being raised and lowered within the housing along a central longitudinal axis of the crystal puller, the charge having an axial centerpoint midway between the surface of the charge and the bottom of the charge, the process comprising
   heating the silicon charge held by the crucible to form a silicon melt having a surface, the crucible being held at a first axial position wherein the distance between the axial centerpoint of the charge and the axial centerpoint of the heater is less than about 15% of the heater length;
   positioning the crucible at a second axial position wherein the distance between the surface of the melt and the axial centerpoint of the heater is less than about 15% of the heater length; and
   maintaining the temperature of the silicon melt above the melting temperature of the charge at the second axial position for at least about 30 minutes.
53. A process as set forth in item 52 wherein the difference in position between the first axial position and the second axial position is less than about 5% of the heater length.
54. A process as set forth in item 52 wherein the first axial position and the second axial position are substantially the same.
55. A process as set forth in any one of items 52-54 wherein the temperature of the silicon melt is maintained above the melting temperature of the charge at the second axial position for at least about 1 hour.
56. A process as set forth in any one of items 52-55 wherein the temperature of the silicon melt is maintained above the melting temperature of the charge at the second axial position for at least about 2 hours.
57. A process as set forth in any one of items 52-56 wherein the melting temperature of the charge is about 1412°C.
58. A process as set forth in item 57 wherein the temperature of the silicon melt is maintained from about 1412°C to about 1575°C at the second axial position for at least about 30 minutes.
59. A process as set forth in item 57 wherein the temperature of the silicon melt is maintained from about 1412°C to about 1575°C at the second axial position for at least about 1 hour.
60. A process as set forth in item 57 wherein the temperature of the silicon melt is maintained from about 1412°C to about 1575°C at the second axial position for at least about 2 hours.
61. A process as set forth in any one of items 52-60 further comprising raising the crucible to a third axial position wherein the surface of the melt is from about 2.5% to about 25% of the heater length below the top of the heater.
62. A process as set forth in any one of items 52-61 wherein the heater length is at least about 300 mm.
63. A process as set forth in any one of items 52-61 wherein the heater length is at least about 400 mm.
64. A process as set forth in any one of items 52-63 wherein the silicon charge comprises silicon powder discharged from a fluidized bed reactor utilized in the chemical vapor deposition of silicon from a thermally decomposable compound.
65. A process as set forth in any one of items 52-64 wherein the silicon charge includes silicon powder particles with an average nominal diameter of less than about 50 µm.
66. A process as set forth in any one of items 52-65 wherein the silicon charge includes at least about 20% silicon powder by weight.
67. A process as set forth in any one of items 52-65 wherein the silicon charge includes at least about 35% silicon powder by weight.
68. A process as set forth in any one of items 52-65 wherein the silicon charge includes at least about 50% silicon powder by weight.
69. A process as set forth in any one of items 52-65 wherein the silicon charge includes at least about 75% silicon powder by weight.
70. A process as set forth in any one of items 52-65 wherein the silicon charge includes at least about 90% silicon powder by weight.
71. A process as set forth in any one of items 52-65 wherein the silicon charge includes at least about 99% silicon powder by weight.
72. A process as set forth in any one of items 52-65 wherein the silicon charge consists essentially of silicon powder.
73. A process as set forth in any one of items 52-72 wherein the silicon charge is heated to a temperature from about 1100°C to a temperature less than about the melting temperature of the silicon charge for at least about 30 minutes to prepare an oxide depleted silicon charge prior to heating the silicon charge to form a silicon melt.
74. A process as set forth in item 73 wherein a portion of the ambient is removed to create a vacuum in the housing prior to heating the silicon charge to a temperature from about 1100°C to a temperature less than about the melting temperature of the silicon, wherein the rate of removal of the ambient is controlled to prevent silicon powder from becoming entrained in the ambient.
75. A process as set forth in any one of items 52-73 wherein a portion of the ambient is removed to create a vacuum in the housing prior to heating the silicon charge to form a silicon melt, wherein the rate of removal of the ambient is controlled to prevent silicon powder from becoming entrained in the ambient.
76. A process as set forth in any one of items 52-75 wherein the crucible comprises a sidewall and wherein there is a gap between a portion of the sidewall and the charge prior to heating the silicon charge to a temperature above the melting temperature of the charge to form a silicon melt.
77. A process for preparing a melt of silicon powder for use in growing a single crystal or polycrystalline silicon ingot in accordance with the Czochralski method, the silicon melt being prepared in a crucible having a bottom and a sidewall having an inner surface, the process comprising
   inserting a removable spacer along the inner surface of the crucible sidewall, the spacer having a top and a bottom;
   loading silicon powder into the crucible to form a silicon charge;
   removing the removable spacer from the crucible to create a gap between the sidewall of the crucible and the silicon charge; and
   heating the silicon charge to a temperature above the melting temperature of the charge to form a silicon melt.
78. A process as set forth in item 77 wherein the silicon powder has a height at the sidewall which is not greater than the height of the top of the removable spacer at the moment before the spacer is removed from the crucible.
79. A process as set forth in item 77 or item 78 wherein silicon powder is loaded into the crucible to form a partial silicon charge before the removable spacer is inserted into the crucible and wherein silicon powder is loaded into the crucible after the removable spacer is inserted to form a complete silicon charge.
80. A process as set forth in any one of items 77-79 wherein the spacer is rectangular in shape.
81. A process as set forth in any one of items 77-80 wherein the spacer is an annulus.
82. A process as set forth in any one of items 77-81 wherein the crucible sidewall is an annulus with an inner circumference and wherein the length of the spacer is at least about the length of the inner circumference of the sidewall.
83. A process as set forth in any one of items 77-82 wherein two removable spacers are inserted into the crucible.
84. A process as set forth in any one of items 77-83 wherein the spacer is at least about 20 mm thick.
85. A process as set forth in any one of items 77-84 wherein the melting temperature of the charge is about 1412°C.
86. A process as set forth in item 85 wherein the charge is heated to a temperature from about 1412°C to about 1575°C to melt the charge.
87. A process as set forth in any one of items 77-86 wherein silicon powder discharged from a fluidized bed reactor utilized in the chemical vapor deposition of silicon from a thermally decomposable compound is loaded into the crucible.
88. A process as set forth in any one of items 77-87 wherein the silicon powder comprises silicon powder particles with an average nominal diameter of less than about 50 µm.
89. A process as set forth in any one of items 77-88 wherein the silicon charge includes at least about 20% silicon powder by weight.
90. A process as set forth in any one of items 77-88 wherein the silicon charge includes at least about 35% silicon powder by weight.
91. A process as set forth in any one of items 77-88 wherein the silicon charge includes at least about 50% silicon powder by weight.
92. A process as set forth in any one of items 77-88 wherein the silicon charge includes at least about 75% silicon powder by weight.
93. A process as set forth in any one of items 77-88 wherein the silicon charge includes at least about 90% silicon powder by weight.
94. A process as set forth in any one of items 77-88 wherein the silicon charge includes at least about 99% silicon powder by weight.
95. A process as set forth in any one of items 77-88 wherein the silicon charge consists essentially of silicon powder.
96. A process as set forth in any one of items 77-95 wherein the silicon charge is heated to a temperature from about 1100°C to a temperature less than about the melting temperature of the silicon charge for at least about 30 minutes to prepare an oxide depleted silicon charge prior to heating the silicon charge to form a silicon melt and wherein a portion of the ambient is removed to create a vacuum in the housing prior to heating the silicon charge to a temperature from about 1100°C to a temperature less than about the melting temperature of the silicon, wherein the rate of removal of the ambient is controlled to prevent silicon powder from becoming entrained in the ambient.
97. A process as set forth in any one of items 77-95 wherein a portion of the ambient is removed to create a vacuum in the housing prior to heating the silicon charge to form a silicon melt, wherein the rate of removal of the ambient is controlled to prevent silicon powder from becoming entrained in the ambient.
98. A process for preparing a melt of silicon powder for use in growing a single crystal or polycrystalline silicon ingot in accordance with the Czochralski method, the process comprising
   loading silicon powder into a crucible having a bottom and a sidewall having an inner surface to form a silicon charge, the silicon powder comprising silicon powder particles with an amount of silicon oxide at their surface;
   inserting a removable spacer along the inner surface of the crucible sidewall, the spacer having a top and a bottom;
   removing the removable spacer from the crucible to create a gap between the sidewall of the crucible and the silicon charge;
   loading the crucible within a housing of a crystal puller for pulling the silicon ingot, the housing comprising an ambient, the crystal puller having a heater in thermal communication with the crucible for heating the crucible to a temperature sufficient to melt the silicon charge, the heater having a top and a bottom defining a heater length and an axial centerpoint midway between the top and the bottom of the heater, the crucible capable of being raised and lowered within the housing along a central longitudinal axis of the crystal puller, the charge having an axial centerpoint midway between the surface of the charge and the bottom of the charge;
   removing a portion of the ambient to create a vacuum in the housing, wherein the rate of removal of the ambient is controlled to prevent silicon powder from becoming entrained in the ambient;
   heating the silicon charge to a temperature from about 1100°C to a temperature less than about the melting temperature of the silicon charge for at least about 30 minutes to prepare an oxide depleted silicon charge;
   heating the oxide depleted silicon charge to a temperature above the melting temperature of the charge to form a silicon melt having a surface, the crucible being held at a first axial position wherein the distance between the axial centerpoint of the charge and the axial centerpoint of the heater is less than about 15% of the heater length;
   positioning the crucible at a second axial position wherein the distance between the surface of the melt and the axial centerpoint of the heater is less than about 15% of the heater length; and
   maintaining the temperature of the silicon melt above the melting temperature of the charge at the second axial position for at least about 30 minutes.
99. A process as set forth in item 98 wherein the silicon charge comprises silicon powder discharged from a fluidized bed reactor utilized in the chemical vapor deposition of silicon from a thermally decomposable compound.
100. A process as set forth in item 98 or item 99 wherein the silicon charge includes silicon powder particles with an average nominal diameter of less than about 50 µm.
101. A process as set forth in any one of items 98-100 wherein the silicon charge includes at least about 20% silicon powder by weight.
102. A process as set forth in any one of items 98-100 wherein the silicon charge includes at least about 35% silicon powder by weight.
103. A process as set forth in any one of items 98-100 wherein the silicon charge includes at least about 50% silicon powder by weight.
104. A process as set forth in any one of items 98-100 wherein the silicon charge includes at least about 75% silicon powder by weight.
105. A process as set forth in any one of items 98-100 wherein the silicon charge includes at least about 90% silicon powder by weight.
106. A process as set forth in any one of items 98-100 wherein the silicon charge includes at least about 99% silicon powder by weight.
107. A process as set forth in any one of items 98-100 wherein the silicon charge consists essentially of silicon powder.

## Claims

1. A process for preparing a melt of silicon powder for use in growing a single crystal or polycrystalline silicon ingot in accordance with the Czochralski method, the silicon powder being loaded into a crucible to form a silicon charge, the crucible being located within a housing of a crystal puller for pulling the silicon ingot, the housing comprising an ambient, the process comprising
removing a portion of the ambient to create a vacuum in the housing, wherein the rate of removal of the ambient is controlled to prevent silicon powder from becoming entrained in the ambient; and
heating the silicon charge to a temperature above the melting temperature of the charge to form a silicon melt.

2. A process as set forth in claim 1 wherein a portion of the ambient is removed to create a vacuum of less than about 300 torr of absolute pressure in the housing, wherein the rate of removal of the ambient is controlled to prevent silicon powder from becoming entrained in the ambient.

3. A process as set forth in claim 2 wherein the period of time the pressure in the housing changes from about atmospheric to about 300 torr is at least about 60 seconds.

4. A process as set forth in claim 2 wherein a portion of the ambient is removed to create a vacuum of less than about 300 torr of absolute pressure in the housing, wherein the rate of removal of the ambient is controlled to prevent silicon powder from becoming entrained in the ambient, and further comprising removing a further portion of the ambient to create a vacuum of less than about 5 torr of absolute pressure.

5. A process for preparing a melt of silicon powder for use in growing a single crystal or polycrystalline silicon ingot in accordance with the Czochralski method, the silicon powder being loaded into a crucible to form a silicon charge, the crucible being located within a housing of a crystal puller for pulling the silicon ingot, the crystal puller having a heater in thermal communication with the crucible for heating the crucible to a temperature sufficient to melt the silicon charge, the heater having a top and a bottom defining a heater length and an axial centerpoint midway between the top and the bottom of the heater, the crucible capable of being raised and lowered within the housing along a central longitudinal axis of the crystal puller, the charge having an axial centerpoint midway between the surface of the charge and the bottom of the charge, the process comprising
heating the silicon charge held by the crucible to form a silicon melt having a surface, the crucible being held at a first axial position wherein the distance between the axial centerpoint of the charge and the axial centerpoint of the heater is less than about 15% of the heater length;
positioning the crucible at a second axial position wherein the distance between the surface of the melt and the axial centerpoint of the heater is less than about 15% of the heater length; and
maintaining the temperature of the silicon melt above the melting temperature of the charge at the second axial position for at least about 30 minutes.

6. A process as set forth in claim 5 wherein the difference in position between the first axial position and the second axial position is less than about 5% of the heater length or, preferably, wherein the first axial position and the second axial position are substantially the same.

7. A process as set forth in claim 5 further comprising raising the crucible to a third axial position wherein the surface of the melt is from about 2.5% to about 25% of the heater length below the top of the heater.

8. A process for preparing a melt of silicon powder for use in growing a single crystal or polycrystalline silicon ingot in accordance with the Czochralski method, the silicon melt being prepared in a crucible having a bottom and a sidewall having an inner surface, the process comprising
inserting a removable spacer along the inner surface of the crucible sidewall, the spacer having a top and a bottom;
loading silicon powder into the crucible to form a silicon charge; removing the removable spacer from the crucible to create a gap between the sidewall of the crucible and the silicon charge; and
heating the silicon charge to a temperature above the melting temperature of the charge to form a silicon melt.

9. A process as set forth in claim 8 wherein the silicon powder has a height at the sidewall which is not greater than the height of the top of the removable spacer at the moment before the spacer is removed from the crucible.

10. A process as set forth in claim 8 or claim 9 wherein silicon powder is loaded into the crucible to form a partial silicon charge before the removable spacer is inserted into the crucible and wherein silicon powder is loaded into the crucible after the removable spacer is inserted to form a complete silicon charge.

11. A process as set forth in claim 1, 5 or 8 wherein the silicon charge comprises silicon powder discharged from a fluidized bed reactor utilized in the chemical vapor deposition of silicon from a thermally decomposable compound.

12. A process as set forth in claim 1, 5 or 8 wherein the silicon powder comprises silicon powder particles with an average nominal diameter of less than about 50 µm.

13. A process as set forth in claim 1, 5 or 8 wherein the silicon charge includes at least about 20% silicon powder by weight or, preferably, about 90% silicon powder by weight.

14. A process as set forth in claim 1, 5 or 8 wherein the silicon charge consists essentially of silicon powder.

15. A process for preparing a melt of silicon powder for use in growing a single crystal or polycrystalline silicon ingot in accordance with the Czochralski method, the process comprising
loading silicon powder into a crucible having a bottom and a sidewall having an inner surface to form a silicon charge, the silicon powder comprising silicon powder particles with an amount of silicon oxide at their surface;
inserting a removable spacer along the inner surface of the crucible sidewall, the spacer having a top and a bottom;
removing the removable spacer from the crucible to create a gap between the sidewall of the crucible and the silicon charge;
loading the crucible within a housing of a crystal puller for pulling the silicon ingot, the housing comprising an ambient, the crystal puller having a heater in thermal communication with the crucible for heating the crucible to a temperature sufficient to melt the silicon charge, the heater having a top and a bottom defining a heater length and an axial centerpoint midway between the top and the bottom of the heater, the crucible capable of being raised and lowered within the housing along a central longitudinal axis of the crystal puller, the charge having an axial centerpoint midway between the surface of the charge and the bottom of the charge;
removing a portion of the ambient to create a vacuum in the housing, wherein the rate of removal of the ambient is controlled to prevent silicon powder from becoming entrained in the ambient;
heating the silicon charge to a temperature from about 1100°C to a temperature less than about the melting temperature of the silicon charge for at least about 30 minutes to prepare an oxide depleted silicon charge;
heating the oxide depleted silicon charge to a temperature above the melting temperature of the charge to form a silicon melt having a surface, the crucible being held at a first axial position wherein the distance between the axial centerpoint of the charge and the axial centerpoint of the heater is less than about 15% of the heater length;
positioning the crucible at a second axial position wherein the distance between the surface of the melt and the axial centerpoint of the heater is less than about 15% of the heater length; and
maintaining the temperature of the silicon melt above the melting temperature of the charge at the second axial position for at least about 30 minutes.
